# EUROPEAN PATENT APPLICATION

(11) **EP 2 657 373 A1**
(43) Date of publication of application: **30.10.2013**
(21) Application number: 12165227.5
(22) Date of filing: 23.04.2012
(51) Int. Cl.: C30B 23/00, C30B 29/36, C30B 35/00

(54) **Crucible for growing crystals**

(71) Applicant: Chung-Shan Institute of Science and Technology, Armaments, Bureau, Ministry of National Defense, Taoyuan County 325, Chinese Taipei (TW)
(72) Inventor: Hsiung, Chih-yung, 325 Taoyuan County (TW); Ma, Dai-liang, 325 Taoyuan County (TW); Peng, Chao-chun, 325 Taoyuan County (TW)
(74) Representative: Lang, Christian

(57) **Abstract**

A crucible is used for allowing a seed crystal to grow via the source of materials. The crucible includes a growth chamber, a holder, a reflecting device, and a plurality of gas guiding devices. The holder is located on the top of the crystal growth chamber for holding the seed. The reflecting device is located around the holder. The plurality of gas guiding devices is located on the bottom of the growth chamber, for containing the material source and guiding the gasification or vaporization of the material source.

## Description

### BACKGROUND OF INVENTION

### 1. FIELD OF INVENTION

The present invention relates to a crucible and, more particularly, to a crucible to provide a dense thermal gradient in thermal radiation for growing crystals.

### 2. RELATED PRIOR ART

Physical Vapor Transport ("PVT") and physical vapor deposition ("PVD") are often used to grow of silicon carbide crystals and mass produce chips. For example, as disclosed in US Patent No. 5746827, silicon carbide crystals are grown in a PVT process. Several problems are encountered in the PVT process. For example, the heat gradient is large. The pressure of the protective gas is low. It is difficult to control the temperature of the seed crystal and the pressure of the sublimation gas. The PVT process is unstable. The yield of the growth of the crystals is poor. Microtubules (or "thermal decomposition pores") or polycrystalline occurs to fail the PVT process.

As disclosed in US Patent 7316747, a thermal radiation process is used to grow quality silicon carbide crystals. The thermal radiation process however suffers some problems. The thermal field is uneven. Thus, the rate of the decomposition of the powder source varies. Hence, the concentrations of the gases in the growth chamber are unstable. Accordingly, the partial pressures in the growth chamber vary. Therefore, it is difficult to control Single polytype.

As disclosed in US Patent No. 6824611, a process is used to control and improve the growth of silicon carbide crystals. However, the silicon reacts with the graphite used in the container so that excessive carbon or silicon is produced to change the compositions of the gases in the sublimation. In addition, the silicon attacks the interior of the container made of the graphite and produces carbon debris which becomes impurity in the silicon carbide crystals and affects the quality of the silicon carbide crystals.

The present invention is therefore intended to obviate or at least alleviate the problems encountered in prior art.

### SUMMARY OF INVENTION

It is the primary objective of the present invention to provide a crucible to provide a dense thermal gradient in thermal radiation for growing crystals.

To achieve the foregoing objectives, the crucible includes a growth chamber for containing a material source, a holder attached to an upper internal portion of the growth chamber for holding a seed crystal, a reflector placed around the holder for reflecting thermal radiation, and a gas-guiding device placed on a lower internal portion of the growth chamber for guiding gas produced by sublimation of the material source.

In another aspect, the gas-guiding device includes needles arranged in groups extending along concentric circles around an axis of the growth chamber.

In another aspect, the gas-guiding device includes rods arranged in groups extending along concentric circles around an axis of the growth chamber.

In another aspect, the gas-guiding device includes gas-guiding elements in the form of concentric annular sheets extending around an axis of the growth chamber.

In another aspect, the gas-guiding device includes a single gas-guiding element in the form of a spiral sheet.

Other objectives, advantages and features of the present invention will be apparent from the following description referring to the attached drawings.

### BRIEF DESCRIPTION OF DRAWINGS

The present invention will be described via detailed illustration of four embodiments referring to the drawings wherein:
FIG. 1 is a cross-sectional view of a crucible according to the first embodiment of the present invention;
FIG. 2 is a cross-sectional view of the crucible shown in FIG. 1 in use;
FIG. 3 is a cross-sectional view of the crucible in another position than shown in FIG. 1;
FIG. 4 is a cross-sectional view of the crucible shown in FIG. 1 in use;
FIG. 5 is a top view of the crucible shown in FIG. 1;
FIG. 6 is a top view of a crucible according to the second embodiment of the present invention;
FIG. 7 is a top view of a crucible according to the third embodiment of the present invention; and
FIG. 8 is a top view of a crucible according to the fourth embodiment of the present invention.

### DETAILED DESCRIPTION OF EMBODIMENTS

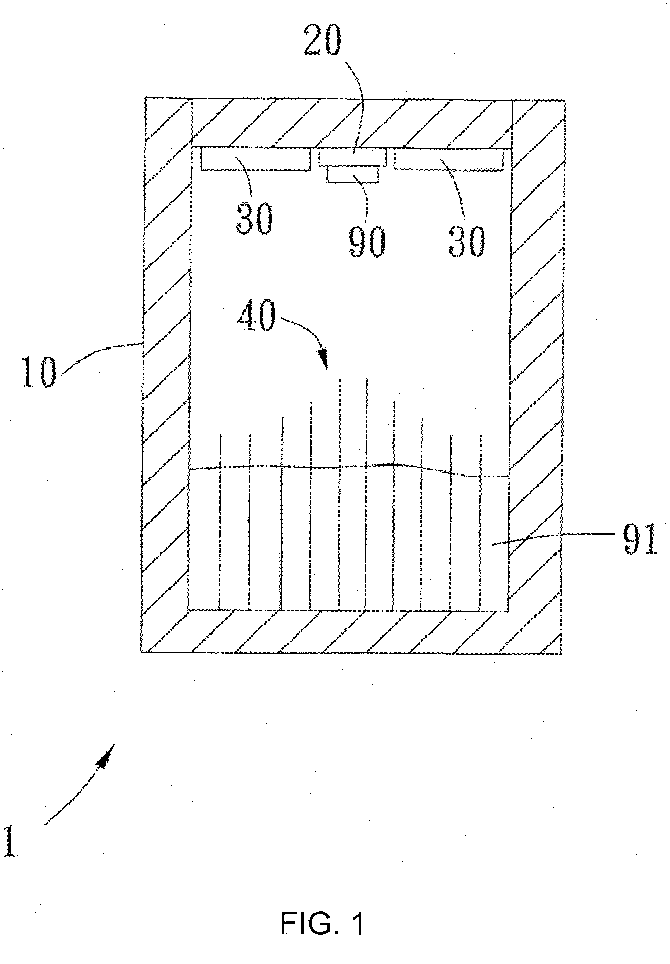

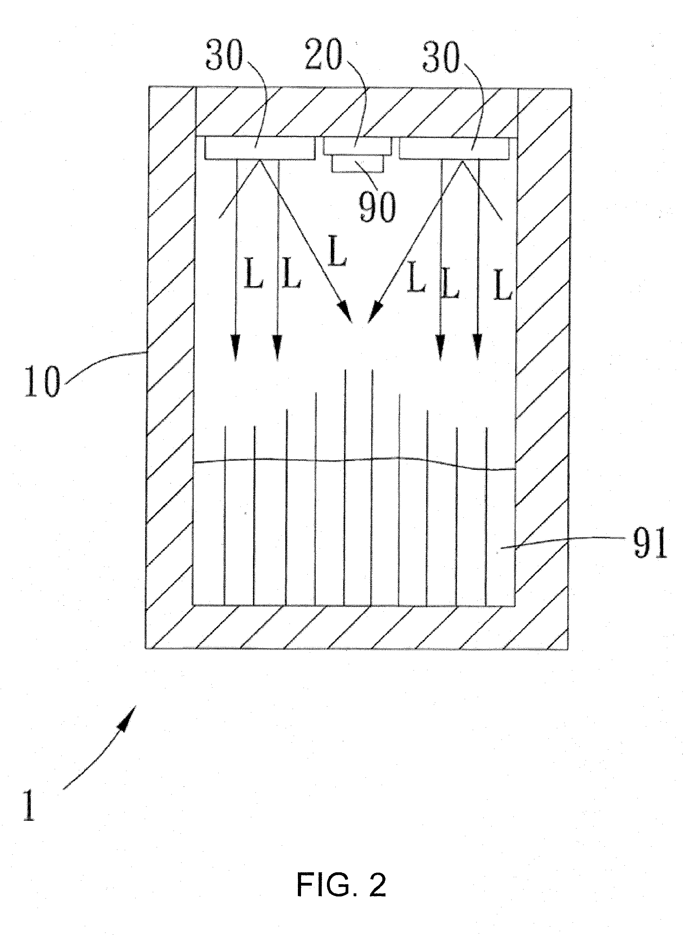

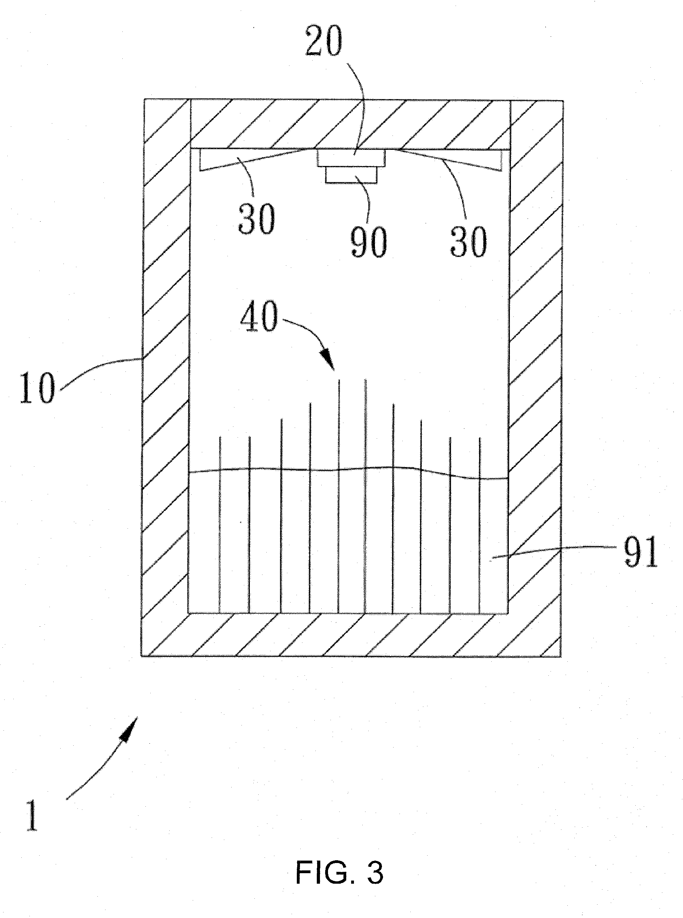

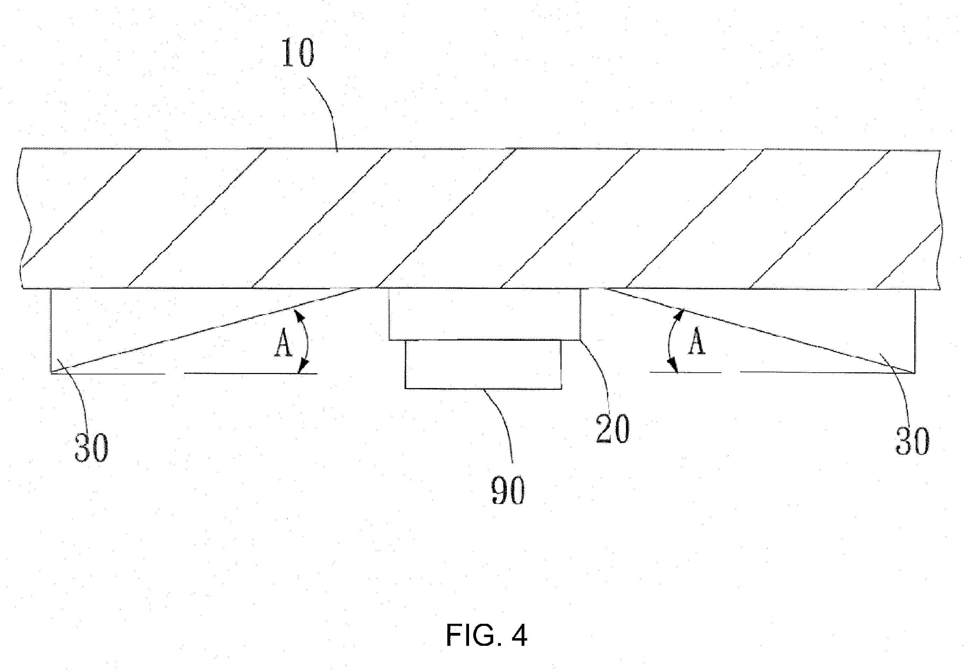

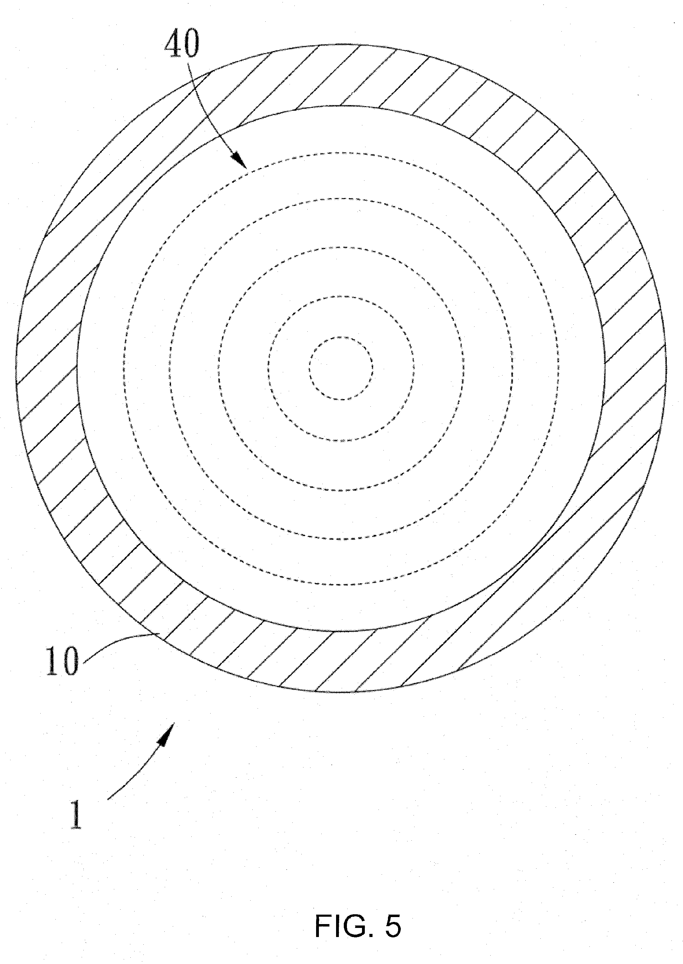

Referring to FIGS. 1 through 5, there is shown a crucible 1 according to a first embodiment of the present invention. In the crucible 1, a seed crystal 90 and a material source 91 are used to grow crystals in a physical vapor transport ("PVT") process, a physical vapor deposition ("PVD") process or any other proper process. The material source 91 is an oxide, a carbide, a nitride, a fluoride, or any other proper material. The crucible 1 includes a growth chamber 10, a holder 20, a reflector 30 and a gas-guiding device.

The growth chamber 10 is used to contain the seed crystal 90 and the material source 91 to grow crystals therein. The growth chamber 10 stands high temperature, and receives heat from an external heat source. The heat is used to grow crystals. The growth chamber 10 includes a cylindrical wall extending about an axis between a ceiling and a floor.

The holder 20 is used to hold the seed crystal 90. The holder 20 is attached to the ceiling of the growth chamber 20.

The reflector 30 is used to reflect thermal radiation L to the gas-guiding device placed in the growth chamber 20. The reflector 30 is attached to the ceiling of the growth camber 20. The reflector 30 is preferably an annular element extending around the holder 20. The reflector 30 is made of a high-temperature metal carbide or the same material as the material source 91.

The reflector 30 stands high temperature in a range of 1500°C to 3000°C or a larger range. The angle A of a lower face of the reflector 30 is changeable in a range of 0 to 30 degrees or a larger range. The angle A of the lower face of the reflector 30 is changeable to change the thermal field, reduce the distribution of temperature in a region influenced by the thermal gradient, and reduce microtubules.

In the first embodiment, the gas-guiding device includes many gas-guiding elements 40 attached to the floor of the growth chamber 10. The gas-guiding elements 40 are divided into several groups extending along evenly distributed concentric circles around the axis of the growth chamber 10. The groups get shorter in a direction toward the cylindrical wall of the growth chamber 10 from the axis of the growth chamber 10. The gas-guiding elements 40 are made of a same height in each group. All of the gas-guiding elements 40 extend higher than the material source 91. The gas-guiding elements 40 are made of a high-temperature metal carbide or the same material as the material source 91. The gas-guiding elements 40 are needles with a dimension of smaller than 2 millimeters.

In operation, heat is introduced into the growth chamber 10 from the external heat source. The material source 91 gets heated and sublimated into gas. The gas ascends, reaches the seed crystal 90, and becomes crystals on the seed crystal 90. The heating, sublimation and crystallization continue so that the material source 91 is completely turned into crystals on the seed crystal 90.

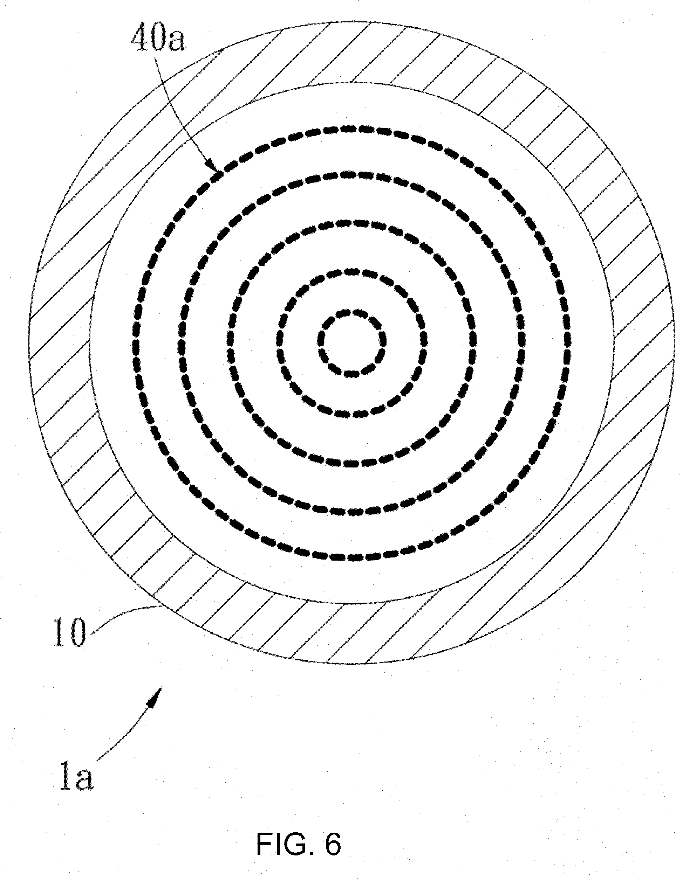

Referring to FIG. 6, there is shown a crucible 1 a according to a second embodiment of the present invention. The second embodiment is identical to the first embodiment except that the gas-guiding device includes gas-guiding elements 40a instead of the gas-guiding elements 40. The gas-guiding elements 40a are rods thicker than the needles 40.

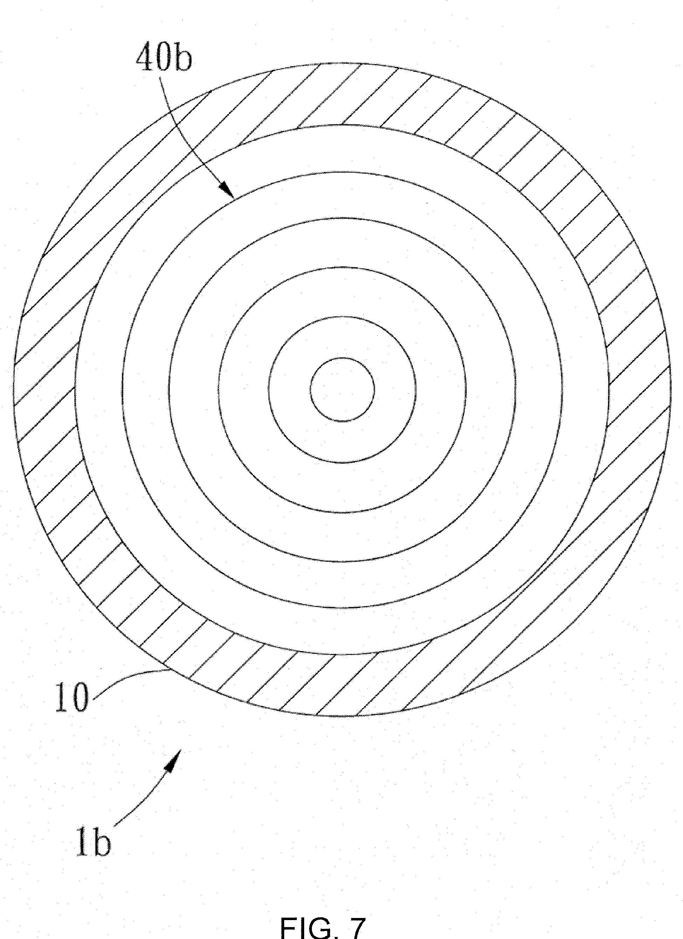

Referring to FIG. 7, there is shown a crucible 1 b according to a third embodiment of the present invention. The third embodiment is identical to the first embodiment except that the gas-guiding device includes gas-guiding elements 40b instead of the gas-guiding elements 40. The gas-guiding elements 40b are annular sheets extending about the axis of the growth chamber 10 in a concentric manner.

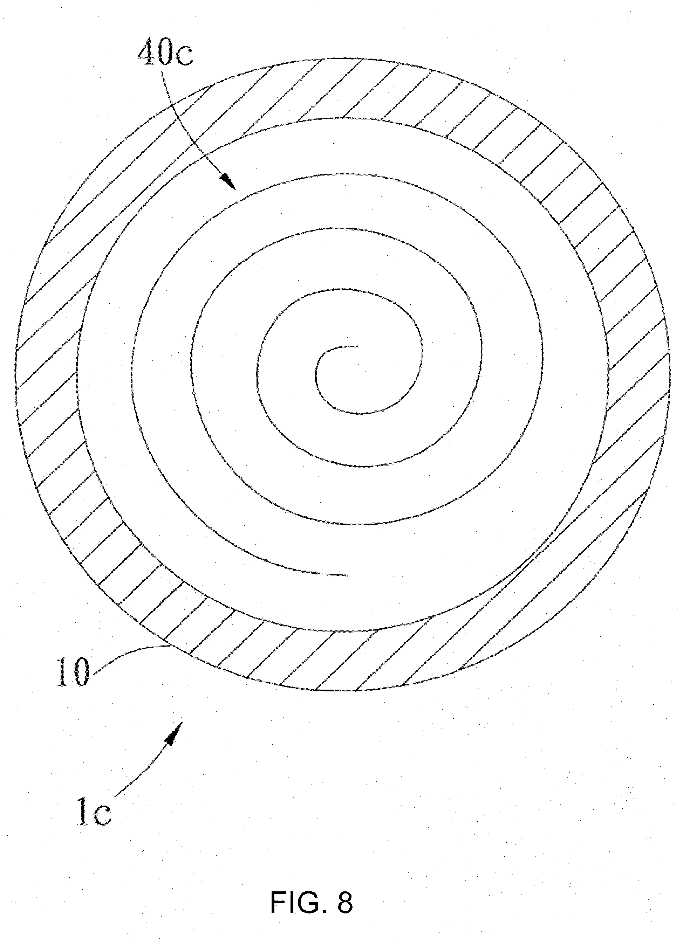

Referring to FIG. 8, there is shown a crucible 1 c according to a fourth embodiment of the present invention. The fourth embodiment is identical to the first embodiment except that the gas-guiding device includes a single gas-guiding element 40c instead of the gas-guiding elements 40a. The gas-guiding element 40c is a spiral sheet.

The present invention has been described via the detailed illustration of the embodiments. Those skilled in the art can derive variations from the embodiments without departing from the scope of the present invention. Therefore, the embodiments shall not limit the scope of the present invention defined in the claims.

## Claims

1. A crucible including:
a growth chamber 10 for containing a material source 91;
a holder 20 attached to an upper internal portion of the growth chamber 10 for holding a seed crystal 90;
a reflector 30 placed around the holder 20 for reflecting thermal radiation L; and
a gas-guiding device placed on a lower internal portion of the growth chamber 10 for guiding gas produced by sublimation of the material source 91.

2. The crucible according to claim 1, wherein the reflector 30 is placed at an angle A that is changeable in a range of 0 to 30 degrees.

3. The crucible according to claim 2, wherein the gas-guiding device includes gas-guiding elements 40, 40a arranged in groups extending along concentric circles around an axis of the growth chamber 10.

4. The crucible according to claim 3, wherein the groups get shorter in an outward radial direction.

5. The crucible according to claim 4, wherein the gas-guiding elements 40, 40a extend higher than the material source 91.

6. The crucible according to claim 5, wherein each of the gas-guiding elements 40 is a needle with a diameter smaller than 2 millimeters or wherein each of the gas-guiding elements 40a is a rod with a diameter larger than 2 millimeters..

7. The crucible according to claim 2, wherein the gas-guiding device includes gas-guiding elements 40b in the form of concentric annular sheets extending around an axis of the growth chamber 10 or wherein the gas-guiding device includes a single gas-guiding element 40c having the form of a spiral sheet.

8. The crucible according to claim 1, wherein the reflector 30 is made of a material selected from the group consisting of a high-temperature metal carbide and a material identical to that of the material source 91, wherein the material source 91 is made of a material selected from the group consisting of an oxide, a carbide, a nitride and a fluoride.

9. The crucible according to claim 1, wherein the gas-guiding element is made of a material selected from the group consisting of a high-temperature metal carbide and a material identical to that of the material source 91, wherein the material source 91 is made of a material selected from the group consisting of an oxide, a carbide, a nitride and a fluoride.

10. The crucible according to claim 9, wherein the gas-guiding element stands high temperature of 1500°C to 3000°C.

11. A reflector for a crucible including a holder 20, wherein the reflector 30 is placed around the holder 20 for reflecting thermal radiation L.

12. The reflector according to claim 11, wherein the reflector 30 is placed at an angle A that is changeable in a range of 0 to 30 degrees.

13. The reflector according to claim 11, wherein the reflector 30 is made of a material selected from the group consisting of a high-temperature metal carbide and a material identical to that of a material source 91, wherein the material source 91 is made of a material selected from the group consisting of an oxide, a carbide, a nitride and a fluoride.

14. A gas-guiding device for guiding gas produced by sublimation of a material source 91 placed in a lower internal portion of a growth chamber 10 of a crucible.

15. The gas-guiding device according to claim 16 including gas-guiding elements 40, 40a arranged in groups extending along concentric circles around an axis of the growth chamber 10, wherein the groups 40, 40a get shorter in an outward radial direction.

16. The gas-guiding device according to claim 15, wherein the gas-guiding elements 40, 40a extend higher than the material source 91.

17. The gas-guiding device according to claim 14 including concentric annular sheets extending around an axis of the growth chamber 10 or including a spiral sheet extending around an axis of the growth chamber 10.

## Amended claims

### Amended claims in accordance with Rule 137(2) EPC.

**1.** A crucible including:
a growth chamber (10) for containing a material source (91);
a holder (20) attached to an upper internal portion of the growth chamber (10) for holding a seed crystal (90);
a reflector (30) placed around the holder (20) for reflecting thermal radiation (L);
**characterized by**
a gas-guiding device placed on a lower internal portion of the growth chamber (10) for guiding gas produced by sublimation of the material source (91), wherein
the gas-guiding device includes gas-guiding elements (40, 40a) arranged in groups extending along concentric circles around an axis of the growth chamber (10), or
the gas-guiding device includes gas-guiding elements (40b) in the form of concentric annular sheets extending around an axis of the growth chamber (10), or
the gas-guiding device includes a single gas-guiding element (40c) having the form of a spiral sheet.

**2.** The crucible according to claim 1, wherein the reflector (30) is placed at an angle (A) that is changeable in a range of 0 to 30 degrees.

**3.** The crucible according to claim 2, wherein the groups get shorter in an outward radial direction.

**4.** The crucible according to claim 3, wherein the gas-guiding elements (40, 40a) arranged in groups extend higher than the material source (91).

**5.** The crucible according to claim 4, wherein each of the gas-guiding elements (40) arranged in groups is a needle with a diameter smaller than 2 millimeters or wherein each of the gas-guiding elements (40a) arranged in groups is a rod with a diameter larger than 2 millimeters.

**6.** The crucible according to claim 1, wherein the reflector (30) is made of a material selected from the group consisting of a high-temperature metal carbide and a material identical to that of the material source (91), wherein the material source (91) is made of a material selected from the group consisting of an oxide, a carbide, a nitride and a fluoride.

**7.** The crucible according to claim 1, wherein the gas-guiding element is made of a material selected from the group consisting of a high-temperature metal carbide and a material identical to that of the material source (91), wherein the material source (91) is made of a material selected from the group consisting of an oxide, a carbide, a nitride and a fluoride.

**8.** The crucible according to claim 7, wherein the gas-guiding element stands high temperature of 1500°C to 3000°C.

**9.** A gas-guiding device for guiding gas produced by sublimation of a material source (91) placed in a lower internal portion of a growth chamber (10) of a crucible
**characterized in that**
the gas-guiding device includes gas-guiding elements (40, 40a) arranged in groups extending along concentric circles around an axis of the growth chamber (10), or
the gas-guiding device includes gas-guiding elements (40b) in the form of concentric annular sheets extending around an axis of the growth chamber (10), or
the gas-guiding device includes a single gas-guiding element (40c) having the form of a spiral sheet.

**10.** The gas-guiding device according to claim 9, wherein the gas-guiding elements (40, 40a) arranged in groups extend higher than the material source (91).
